(19) Europäisches Patentamt
European Patent Office
Office européen des brevets

(11) **EP 3 378 585 A1**

(12) **EUROPEAN PATENT APPLICATION**
published in accordance with Art. 153(4) EPC

(43) Date of publication:
**26.09.2018 Bulletin 2018/39**

(21) Application number: **16865913.4**

(22) Date of filing: **01.11.2016**

(51) Int Cl.:
**B22F 7/08** (2006.01)  **B22F 1/02** (2006.01)
**C09J 1/00** (2006.01)  **C09J 11/06** (2006.01)
**H01B 1/22** (2006.01)  **H05K 3/32** (2006.01)
**B22F 1/00** (2006.01)

(86) International application number:
**PCT/JP2016/004781**

(87) International publication number:
**WO 2017/085909 (26.05.2017 Gazette 2017/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **16.11.2015 JP 2015223648**

(71) Applicant: **Bando Chemical Industries, Ltd.**
**Kobe-shi, Hyogo 650-0047 (JP)**

(72) Inventor: **NAKAJIMA, Naoya**
**Kobe-shi**
**Hyogo 650-0047 (JP)**

(74) Representative: **Gill, Stephen Charles**
**Mewburn Ellis LLP**
**City Tower**
**40 Basinghall Street**
**London EC2V 5DE (GB)**

(54) **BONDING COMPOSITION**

(57) A bonding composition which can give high bonding strength by a relatively low bonding temperature, and at the same time, can inhibit the formation of the fillet while maintaining the sufficient spreading over the interface to be bonded, is provided. The present invention is related to a bonding composition comprising inorganic particles as a primary component and an organic component as a secondary component, wherein a viscosity of the composition decreases upon a rise in temperature, and the inorganic particles are sintered to each other following the decrease in viscosity. It is preferred that the viscosity at around 25 °C of the bonding composition is 10 to 50 Pa·s at a shear of 10 s$^{-1}$.

EP 3 378 585 A1

**Description**

TECHNICAL FIELD

The present invention relates to a bonding composition which is composed of inorganic particles as a primary component and an organic component as a secondary component.

BACHGROUND ARTS

In order to mechanically and/or electrically and/or thermally bond a metal component and another metal component, there have been used conventionally, a solder, a conductive adhesive, a silver paste, an anisotropically-conductive film, and the like. The conductive adhesive, silver paste, and anisotropically-conductive film are sometimes used when bonding not only the metal components but ceramic components, resin components. For example, there are bonding of a light-emitting element such as LED (Light Emitting Diode) to a substrate, bonding of a semiconductor chip to a substrate, and further bonding of these substrates to a heat dissipation member.

Among them, an adhesive, paste and film which contain the solder and a conductive filler made of a metal are used for bonding at a portion requiring an electric connection. In addition, since a metal generally has a high thermal conductivity, these paste and film which contain the solder and a conductive filler made of a metal may be used for increasing in heat dissipation.

Particularly, when an illumination device or a light-emitting device with high brightness is produced by using a light-emitting element such as LED, a calorific value tends to increase. In addition, since a temperature of the light-emitting element such as LED is increased by the external heating at the bonding, it is necessary to prevent the element from the damage at the bonding by lowering the bonding temperature as long as possible. From these points of view, a bonding material which can give sufficient bonding strength at a low bonding temperature and also has a sufficient heat dissspation property is strongly desired.

To the contrary, as a replacing material for a high temperature solder, there has been developed a bonding material where metal nanoparticles of a noble metal such as silver or gold are used. For example, as disclosed in Patent Literature 1 (Japanese Patent Laid-Open Application 2008-178911), there has been disclosed a bonding composition including a metal particle precursor being at least one selected from the group consisting of a particle of a metal oxide, a particle of a metal carbonate, and a particle of a metal carboxylate and having an average particle diameter of 1 nm to 50 $\mu$m and a reducing agent composed of an organic substance, wherein the content of the metal particle precursor is more than 50 parts by mass and not more than 99 parts by mass per the whole parts by mass of the bonding material, and when the rate of weight loss of the reducing agent at the heating up to 400°C is 99 % or more, good metal bonding can be realized.

Here, when the bonding composition is practically used for bonding the LED, etc., it is necessary to consider easiness of applying the bonding composition and spreading of the bonding composition on the interface to be bonded, but such views are not studied in the bonding material described in Patent Literature 1.

In addition, it is requited that the LED has excellent light emitting efficiency and a long life, and these properties also depend upon the bonded manner to a substrate. More specifically, when a fillet is formed at the bonded part, the fillet inhibits the light emission of the LED and also it is difficult to maintain the light emission strength for a long time due to coloration of the fillet with laps of time. However, there is no consideration as to the formation of the fillet in the bonding material described in the above Patent Literature 1.

PRIOR ART LITERATURE

Patent Literature

Patent Literature 1: Japanese Patent Laid-Open Application 2008-178911

SUMMARY OF INVENTION

Problem to be Solved by the Invention

In light of the circumstances above, the objective of the present invention is to provide a bonding composition which can achieve high bonding strength by bonding at a relatively low temperature and which can suppress formation of fillets while maintaining suitable spreading at an interface to be bonded.

Means for solving the problems

In order to accomplish the above objective, the result of the present inventor's intensive study as to the composition and viscosity, etc. of the bonding composition, it has been found that the above objective can be accomplished effectively by appropriately lowering the viscosity by rising temperature with respect to a bonding composition which comprises inorganic particles as a primary component and an organic component as a secondary component, and then the present invention has been completed.

Namely, the present invention can provide a bonding composition comprising inorganic particles as a primary component and an organic component as a secondary component, wherein

a viscosity of the composition decreases upon a rise in temperature, and

the inorganic particles are sintered to each other following the decrease in viscosity.

Here, the "primary component" shows a component having a content of about 80 to 99 % by mass, and the "secondary component" shows a component having a content of about 1 to 20 % by mass. In some cases, the primary component and/or the secondary component may contain two or more components, respectively.

In the bonding composition of the present invention, the viscosity is lowered during the temperature rising step, and after the bonding composition is wetted and spread all over the desired interface to be bonded due to the lowering of the viscosity, the inorganic particles of the primary component are sintered, and thereby it is possible to form a good bonded layer without non-bonded part all over the surface. In addition, when the bonding composition is wetted and spread appropriately, it is possible to inhibit the formation of the fillet.

Further, in the bonding composition of the present invention, a viscosity at around 25 °C is preferably 10 to 50 Pa·s at a shear of 10 s$^{-1}$. When the viscosity at around 25 °C is 10 Pa·s or more at a shear of 10 s$^{-1}$, it is possible to inhibit the formation of the fillet by flowing out the bonding composition at mounting a chip due to too high flowability of the bonding composition. Further, when the viscosity at around 25 °C is 50 Pa·s or less at a shear of 10 s$^{-1}$, it is possible to prevent that the bonding composition becomes hard and (due to less flowability) is difficult to be applied.

Further, in the bonding composition of the present invention, a viscosity at around 60 °C is preferably 1 to 10 Pa·s at a shear of 10 s$^{-1}$. When the viscosity at around 60 °C is 1 Pa·s or more at a shear of 10 s$^{-1}$, it is possible to inhibit the formation of the fillet beyond the interface to be bonded because of too high flowability of the bonding composition during the temperature rising. Further, when the viscosity at around 60 °C is 10 Pa·s or less at a shear of 10 s$^{-1}$, it is possible to inhibit that non-bonded part is formed because the bonding composition cannot be spread all over the surface to be bonded due to less flowability of the bonding composition.

An average particle size of the inorganic particles in the bonding composition according to the present invention is suitable to be nano meter size where a melting point depression is caused, and more preferable is 1 to 200 nm, and, as occasion demand, it may be possible to add metal particles of micron meter size in addition to the above metal particles of nano meter size. In this case, the bonding is accomplished by depressing the melting point of the particles of nano meter size around the particles of micron meter size.

It is preferable that the aforementioned organic component adheres on the at least a part of the surface of the inorganic particle (namely, at least a part of the surface of the inorganic particle is covered with an organic protective layer composed of the aforementioned organic component). In order to restore the inorganic particle having nano meter size which shows an ability of melting point depression, it is necessary to cover at least a part of the surface of the inorganic particle. Here, since the functional group of the amine can adsorb on the surface of the inorganic particle at an appropriate strength, it is suitably used as the organic protective layer.

When the bonding composition of the present invention is heated up to 500 °C in an atmospheric circumstance, organic substances and the like are oxidatively decomposed and a majority is gasified and disappears. In case that a mass loss when heating the bonding composition from a room temperature to 500°C at a temperature rising rate of 10 °C/min in an atmospheric circumstance is more than 20 % by mass, the organic substances remain in the sintered layer (bonding layer) after the sintering to form voids, which results in the lowering of the bonding strength and the lowering of the conductivity of the sintered layer (bonding layer). To the contrary, in case that the mass loss when heating the bonding composition from a room temperature to 500°C at a temperature rising rate of 10 °C/min in an atmospheric circumstance is 20 % by mass or less, it is possible to obtain a sintered layer (bonding layer) having a high conductivity even at a low temperature bonding at around 200°C. On the other hand, when the mass loss of the bonding composition is too small, since dispersion stability in the colloidal state is damaged, the mass loss when heating the bonding composition from a room temperature to 500°C at a temperature rising rate of 10 °C/min in an atmospheric circumstance is preferably 0.1 to 20.0 % by mass, more preferably 0.5 to 18.0 % by mass.

Further, in the bonding composition of the present invention, the inorganic particles are preferably at least one type of metallic particles out of gold, silver, copper, nickel, bismuth, tin and platinum group elements. If the composition for bonding with such configuration is used, superior bonding strength and thermal resistance can be obtained.

Further, it is preferable that in the bonding composition of the present invention, the organic component contains amine and/or carboxylic acid. Further, in the amine, the amino group in one molecule has a relatively high polarity to generate interaction due to hydrogen bond, and the remaining part other than the functional group shows a relatively low polarity. Further, the amino group tends to show acidic property. In addition, when the amine is localized (adhered) to at least a part of the surface of the inorganic particles (namely, at least a part of the surface of the inorganic particles being covered with) in the bonding composition according to the present invention, it is possible to make the organic component and the inorganic particles affinity enough to prevent the inorganic particles from coagulation (enhancing dispersibility). Namely, since the functional group of the amine adsorbs to the surface of the inorganic particles in a proper strength to prevent the contact of the inorganic particles to each other, the amine contributes the stability of the inorganic particles in a shell life. Further, at the bonding temperature, by moving and or volatizing from the surface of the inorganic particles, the fusion of the inorganic particles with each other and the bonding of the inorganic particles to the substrate may be promoted.

Further, in the carboxylic acid, the carboxyl group in one molecule has a relatively high polarity to generate interaction due to hydrogen bond, and the remaining part other than the functional group shows a relatively low polarity. Further, the carboxyl group tends to show acidic property. In addition, when the carboxylic acid is localized (adhered) to at least a part of the surface of the inorganic particles (namely, at least a part of the surface of the inorganic particles being covered with) in the bonding composition according to the present invention, it is possible to make the organic component and the inorganic particles affinity enough to prevent the inorganic particles from coagulation (enhancing dispersibility). The carboxyl group is easy to coordinate to the surface of the inorganic particles, it is possible to enhance the prevention of the inorganic particles from coagulation. Furthermore, since the hydrophobic group coexists with the hydrophilic group, there is an effect that the wettability between the bonding composition and the bonding substrate can be increased drastically.

Further, in case of adding a dispersion medium as occasion demand, since the organic component acts as a dispersant, a dispersion state of the inorganic particles in the dispersion medium is remarkably improved. Namely, according to the bonding composition of the present invention, it is difficult that inorganic particles agglutinate and dispersibility of the inorganic particles is excellent in a coating film, and are uniformly fused and a strong bonding strength is obtained.

Here, the bonding composition of the present invention is, more specifically, a composition that consists primarily of colloidal particles made from inorganic particles and an organic substance, and may be a colloidal dispersion liquid further containing a dispersion medium. "Dispersion medium" is to disperse the colloidal particles into a dispersion liquid, but a portion of structural components of the colloidal particles may be dissolved into "dispersion medium". Furthermore, "primary component" is a component with the greatest content out of the structural components.

Furthermore, according to the bonding composition of the present invention, it is preferable that
in case of an LED (Light Emitting Diode) chip is laminated on a substrate where the bonding composition is applied, and the substrate and the LED (Light Emitting Diode) chip is bonded by sintering the bonding composition;
a sintered layer of the bonding composition is formed over almost of the interface of the substrate and the LED (Light Emitting Diode) chip,
a height of a fillet of the bonding composition formed at a side surface of the LED (Light Emitting Diode) chip is less than 10 μm.

When the height of a fillet of the bonding composition formed at a side surface of the LED (Light Emitting Diode) chip is less than 10 μm, it is possible to inhibit extremely effectively the lowering of the light-emitting efficiency of an LED package which is caused by the formation of the fillet. Here, the height of the fillet means a length from the surface of the substrate to the highest position of the sintered layer of the bonding composition which is formed at the side surface of the LED (Light Emitting Diode) chip, and can be easily measured by using a video microscope, etc.

Further, the present invention can also provide a bonded body of electronic parts where an LED (Light Emitting Diode) is bonded to a substrate, wherein
a sintered layer of the bonding composition is formed over almost of an interface of the substrate and the LED (Light Emitting Diode) chip, and
a height of a fillet of the bonding composition formed at a side surface of the LED (Light Emitting Diode) chip is less than 10 μm.

When the substrate and the LED (Light Emitting Diode) chip are bonded by using the bonding composition of the present invention, it is possible to obtain the filletless bonded body of electronic parts. Here, the filletless means that the height of a fillet of the bonding composition formed at a side surface of the LED (Light Emitting Diode) chip is less than 10 μm.

In the bonded body of electronic parts of the present invention, since the height of the fillet is less than 10 μm, the prevention of the LED light emission by the fillet is inhibited, and in addition, the light emission strength for a long time due to coloration of the fillet with laps of time is also inhibited. As a result, the LED of the bonded body of electronic parts according to the present invention has excellent light emitting efficiency and a long life.

Effect of the invention

The present invention can provide a bonding composition which can give high bonding strength by a relatively low bonding temperature, and at the same time, can inhibit the formation of the fillet while maintaining the sufficient spreading over the interface to be bonded.

Means for Solving the Problem

Hereafter, one preferred embodiment of the bonding composition of the present invention will be explained in detail. Furthermore, the description below merely indicates one embodiment of the present invention, and the present invention shall not be limited to these, and redundant descriptions may be omitted.

(1) Bonding composition

The bonding composition according to the present embodiment is a bonding composition which contains inorganic particles as a primary component and an organic component as a secondary component. In the following, each component of the bonding composition is explained.

(1-1) Inorganic particles

Though the inorganic particles of the bonding composition according to the present embodiment are not particularly limited, since conductivity of a bonding layer obtained by using the bonding composition according to the present embodiment can be improved, it is preferable to be metal particles where ionization tendency is smaller (nobler) than zinc.

Examples of the metal include at least one of gold, silver, copper, nickel, bismuth, tin, iron, and platinum group elements (ruthenium, rhodium, palladium, osmium, iridium, and platinum). As the metal, particles of at least one of metal selected from the group consisting of gold, silver, copper, nickel, bismuth, tin and the platinum group is preferable, and more preferable is copper or a metal where its ionization tendency is smaller (nobler) than copper, i.e., at least one of gold, platinum, silver and copper. These metals may be used alone or in combination of two or more, and as a method for combination, there is a case of using alloy particles containing a plurality of metals, or a case of using metal particles having a core-shell structure or a multilayered structure.

For example, when silver particles are used for the inorganic particles of the bonding composition, electroconductivity of the adhered layer formed by using the bonding composition according to the present embodiment becomes excellent, but in light of the problem of migration, it can become difficult for the migration to occur by using the bonding composition made of silver and other metals. As "other metals", metals where its ionization series above is nobler than hydrogen, i.e., gold, copper, platinum and palladium are preferable.

The average particle size of the inorganic particle (or inorganic colloid particle) in the bonding composition of the present embodiment has an average particle size so as to cause melting point depression, and for example, may be 1 to 200 nm, preferably 2 to 100 nm. When the average particle size of the inorganic particle is 1 nm or over, a bonding composition that can form an excellent adhesive layer is obtained, and the inorganic particle manufacturing will not cause increase in cost, and it is practical. Further, when 200 nm or less, it is difficult for dispersibility of the inorganic particles to change with time, and it is preferable.

Furthermore, it is also possible to add in conjunction with inorganic particles with size of micron meters as occasion demand. In such case, the bonding can be accomplished by the melting point depression of the inorganic particles with size of nano meter around the inorganic particles with size of micron meter.

The particle size of the inorganic particles in the bonding composition of the present embodiment may not be uniform. Further, in case that the bonding composition contains a dispersion medium, a polymer dispersing agent, a resin component, a thickener or a surface tension adjuster, or the like mentioned after as an optional component, though there is a case that an inorganic colloid particle component having an average particle size of more than 200 nm, any particle component having an average particle size of more than 200 nm may be contained, as long as the component does not cause agglomeration or does not remarkably impair the effects of the present invention.

Here, the average particle size of the inorganic particles in the bonding composition (inorganic colloid dispersion) according to the present embodiment can be measured with a dynamic light scattering method, a small-angle X-ray scattering method or a wide-angle X-ray diffraction method. In order to show depression of the melting point of the metal particles with a nano size, a crystallite diameter obtained with the X-ray diffraction method is suitable. For example, in the wide-angle X-ray diffraction method, to be more specific, the particle size can be measured within the range where $2\theta$ is 30 ° to 80 ° with the diffraction method using RINT-Ultima III available from Rigaku Corporation. In this case, samples should be measured by thinning so as to be a flat surface on a glass plate with approximately 0.1 to 1 mm in depth of a concave portion in the center portion. Further, the crystallite diameter (D) calculated by substituting a half bandwidth of obtained diffraction spectrum using JADE available from Rigaku Corporation into the Scherrer equation should be regarded as the average particle size.

$$D = K\lambda / B\cos\theta$$

Herein, K: Scherrer constant (0.9), λ: wavelength of X-ray, B: half bandwidth of diffraction line, θ: Bragg angle.

(1-2) Organic component

In the bonding composition according to the present embodiment, the organic component adhered at least onto a part of surfaces of the inorganic particles, namely the "organic component" in the inorganic colloid particles, substantially constitutes the inorganic colloid particles along with the inorganic particles as a so-called dispersant. It is a concept that the organic component does not include an organic substance where its trace amount is adhered onto the inorganic particles and the like, such as a trace of an organic substance contained in metal initially as an impurity, a trace of an organic substance where it is mixed during the manufacturing process and is adhered onto a metallic component, a residual reducing agent or residual dispersant that could not be removed during the cleaning process. Furthermore, "trace amount" above specifically indicates less than 1 % by mass in the inorganic colloid particles.

The above organic component is an organic substance which can prevent the inorganic particles from agglomeration by adhering to the inorganic particles, and can form the inorganic colloid particles, and the morphology of coating is not particularly defined, but in the present embodiment, the organic component is preferably contains an amine and a carboxylic acid from viewpoints of dispersibility and conductivity. It is seemed that, when those organic components are chemically or physically bonded to the inorganic particles, the organic component may be converted to an anion or a cation, and in the present embodiment, the above organic components include such an ion or complex derived from the organic components.

The amines used herein may be linear or branched, and may have a side chain. Examples include an alkylamine (linear alkylamine or may have an side chain) such as butylamine, pentylamine, hexylamine, octylamine or dodecylamine; a cycloalkylamine such as cyclopentylamine or cyclohexylamine; a primary amine such as aniline or allylamine; a secondary amine such as dipropylamine, dibutylamine, piperidine or hexamethyleneimine; and a tertiary amine such as tripropylamine, dimethylpropanediamine, cyclohexyldimethylamine, pyridine or quinoline, and the like. The reason why the above amines are listed is that the sintering of the bonding materials is desired to be achieved at a low temperature (200 to 250°C). Therefore, a dispersing agent having a low boiling point (preferred lower limit being around 200°C) is preferably used as the dispersing agent so as to be removed and volatized from the surface of the particle.

The above amine may be a compound containing a functional group other than amine, such as a hydroxyl group, a carboxyl group, an alkoxy group, a carbonyl group, an ester group or a mercapto group. Further, the amine may be used alone or in combination of two or more. In addition, in order to exhibit the low temperature sintering property by removing and volatizing from the surface of the particle, a boiling point at a normal pressure is preferably 300°C or less, further preferably 250°C or less.

The bonding composition according to the present embodiment may contain a carboxylic acid in addition to the amine within the scope that does not impair the effect of the present invention. In the carboxylic acid, the carboxyl group in one molecule has a relatively high polarity to generate interaction due to hydrogen bond, and the remaining part other than the functional group shows a relatively low polarity. Further, the carboxyl group tends to show acidic property. In addition, when the carboxylic acid is localized (adhered) to at least a part of the surface of the inorganic particles (namely, at least a part of the surface of the inorganic particles being covered with) in the bonding composition according to the present embodiment, it is possible to make the organic component and the inorganic particles affinity enough to prevent the inorganic particles from coagulation (enhancing dispersibility).

As the carboxylic acid, a compound having at least one carboxyl group can be broadly used, and example include formic acid, oxalic acid, acetic acid, hexane acid, acrylic acid, octylic acid, oleic acid and the like. A carboxyl group in a part of the carboxylic acid may form a salt with a metallic ion. Furthermore, as to the metal ion, two or more of metal ions may be contained.

The carboxylic acid may be a compound containing a functional group other than carboxyl group such as amino group, hydroxyl group, an alkoxy group, carbonyl group, an ester group or mercapto group. In this case, the number of carboxyl groups is preferably more than the number of functional groups other than carboxyl groups. Further, the carboxylic acid may be used alone, respectively, or in combination of two or more. In addition, in order to exhibit the low temperature sintering property by removing and volatizing from the surface of the particle, it is preferable that a boiling point at a normal pressure is preferably 300°C or less, further preferably 250°C or less. Further, an amine and a carboxylic acid form an amide. Therefore, since the amide group is appropriately adsorbed on the surface of the silver particle, the amide group may be contained in the organic component.

The content of the organic component in the inorganic colloid in the bonding composition of the present embodiment is preferably 0.5 to 50 % by mass. When the content of the organic component is 0.5 % by mass or more, the storage stability of the obtained bonding composition tends to be better, and when 50 % by mass or less, the conductivity of the bonding composition tends to be better. The content of the organic component is more preferably 0.5 to 30 % by mass, further preferably 0.5 to 15 % by mass.

As a composition ratio (mass) in case of using in combination of the amine and the carboxylic acid, it can be optionally selected within the range of 1/99 to 99/1, and is preferably 20/80 to 98/2, further preferably 30/70 to 97/3. Furthermore, for the amine or carboxylic acid, several kinds of amines or carboxylic acids may be used, respectively.

In the bonding composition of the present embodiment, in addition to the components above, within the scope that does not impair the effect of the present invention, in order to add functions such as appropriate viscosity, adhesiveness, drying characteristics or printability, according to purpose for uses, optional components such as a dispersing medium, a polymer dispersing agent, an oligomer component that fulfills, for example, a role of binder, a resin component, an organic solvent (a portion of solid may be dissolved or dispersed), a surfactant, a thickener or a surface tension adjuster may be added. Such optional components are not particularly limited.

As the dispersing medium among the optional components, various components are usable within the scope that does not impair the effect of the present invention, and examples include a hydrocarbon, an alcohol and the like. Among them, the boiling point of the dispersing agent is preferably 200°C or more. When the boiling point is low, since the dispersing agent is volatized early in the course of the temperature rising, the desired lowering of the viscosity tends to be difficult.

Examples of the hydrocarbon include an aliphatic hydrocarbon, a cyclic hydrocarbon, an alicyclic hydrocarbon, an unsaturated hydrocarbon, and the like, and they may be used alone, respectively, or in combination of two or more.

Examples of the aliphatic hydrocarbon include a saturated or unsaturated aliphatic hydrocarbon such as tetradecane, octadecane, heptamethylnonane, tetramethylpentadecane, hexane, heptan, octane, nonane, decane, tridecane, methylpentane, normal paraffin or isoparaffin, and the like.

Examples of the cyclic hydrocarbon include toluene, xylene, and the like.

Further, examples of the alicyclic hydrocarbon include limonene, dipentene, terpinene, terpinene, nesol, cinene, orange flavor, terpinolene, terpinolene, phellandrene, menthadiene, terebene, cymene, dihydrocymene, moslene, kautschin, cajeputen, pinene, terebine, menthane, pinane, terpene, cyclohexane, and the like.

Examples of the unsaturated hydrocarbon include ethylene, acetylene, benzene, 1-hexene, 1-octene, 4-vinylcyclohexene, a terpene-based alcohol, allyl alcohol, oleyl alcohol, 2-paltoleic acid, petroselinic acid, oleic acid, elaidic acid, thiocyanic acid, ricinoleic acid, linolic acid, linoekaidic acid, linoleic acid, arachidonic acid, acrylic acid, methacrylic acid, gallic acid, salicylic acid, and the like.

Among them, an unsaturated hydrocarbon having hydroxyl group is preferable. The hydroxyl group is easy to coordinate with the surface of the inorganic particles to inhibit the coagulation of the inorganic particles. Examples of the unsaturated hydrocarbon having hydroxyl group include a terpene-based alcohol, allyl alcohol, oleyl alcohol, thiocyanic acid, ricinoleic acid, gallic acid, salicylic acid, and the like. Preferable is an unsaturated fatty acid having hydroxyl group such as thiocyanic acid, ricinoleic acid, gallic acid, salicylic acid, and the like.

The above unsaturated hydrocarbon is preferably ricinoleic acid. Ricinoleic acid has carboxyl group and hydroxyl group, and adsorbs on the surface of the inorganic particles to disperse the inorganic particles uniformly and accelerates the fusion of the inorganic particles.

Further, the alcohol is a compound containing one or more OH groups in the molecular structure, and examples include an aliphatic alcohol, a cyclic alcohol and an alicyclic alcohol, and they can be used alone, respectively, or in combination of two or more. Further, a part of the OH groups may be converted to an acetoxy group or the like within a scope that does not impair the effect of the present invention.

Examples of the aliphatic alcohol include a saturated or unsaturated $C_{6-30}$ aliphatic alcohol such as heptanol, octanol (such as 1-octanol, 2-octanol or 3-octanol), nonanol, decanol (such as 1-decanol), lauryl alcohol, tetradecyl alcohol, cetyl alcohol, isotridecanol, 2-ethyl-1-hexanol, octadecyl alcohol, hexadecenol or oleyl alcohol.

Examples of the cyclic alcohol include cresol, eugenol, and the like.

Further, examples of the alicyclic alcohol include a cycloalkanol such as cyclohexanol; a terpene alcohol (monoterpene alcohol, or the like) such as terpineol (including $\alpha$, $\beta$ and $\gamma$ isomers, or any mixture thereof) or dihydroterpene; dihydroterpineol; myrtenol; sobrerol; menthol; carveol; perillyl alcohol; pinocarveol; verbenol, Telsolve (MTPH), and the like.

The content in case of containing a dispersing medium in the bonding composition according to the present embodiment should be adjusted according to desired characteristics such as viscosity, and the content of the dispersion medium in the composition for bonding is preferably 1 to 30 % by mass. When the content of the dispersing medium is 1 to 30 % by mass, an effect to adjust the viscosity can be obtained within the range that is easy to operate as a composition for bonding. The content of the dispersing medium is more preferably 1 to 20 % by mass, further preferably 1 to 15 % by mass. When the content of the dispersing medium is too large, it is afraid that many voids due to the volatizing of the dispersing medium are generated in the bonding layer.

As the above polymer dispersant, any commercial polymer dispersant can be used. Examples of the commercially available polymer dispersant include include SOLSPERSE 11200, SOLSPERSE 13940, SOLSPERSE 16000, SOLSPERSE 17000, SOLSPERSE 18000, SOLSPERSE 20000, SOLSPERSE 24000, SOLSPERSE 26000, SOLSPERSE 27000 and SOLSPERSE 28000 (available from Lubrizol Japan Corporation); DISPERBYK 142, DISPERBYK 160, DISPERBYK 161, DISPERBYK 162, DISPERBYK 163, DISPERBYK 166, DISPERBYK 170, DISPERBYK 180, DISPERBYK 182, DISPERBYK 184, DISPERBYK 190 and DISPERBYK 2155 (available from BYK Japan KK); EFKA-46, EFKA-47, EFKA-48 and EFKA-49 (available from EFKA Chemicals); Polymer 100, Polymer 120, Polymer 150, Polymer 400, Polymer 401, Polymer 402, Polymer 403, Polymer 450, Polymer 451, Polymer 452, Polymer 453 (available from EFKA Chemicals); Ajisper PB711, Ajisper PA111, Ajisper PB811 and Ajisper PW911 (available from AJINOMOTO Co., Ltd.); Flowlen DOPA-15B, Flowlen DOPA-22, Flowlen DOPA-17, Flowlen TG-730W, Flowlen G-700 and Flowlen TG-720W (available from KYOEISHA CHEMICAL Co., Ltd.), and the like. Among them, SOLSPERSE 11200, SOLSPERSE 13940, SOLSPERSE 16000, SOLSPERSE 17000, SOLSPERSE 18000, SOLSPERSE 28000, DISPERBYK 142 or DISPERBYK 2155 is preferable from the viewpoint of low-temperature sinterability and dispersing stability.

A content of the polymer dispersant is preferably 0.1 to 15 % by mass. When the content of the polymer dispersant is 0.1 % or more, the dispersibility of the obtained composition for bonding becomes better, but when the content is too larger, the bonding property becomes worse. From this point of view, the content of the polymer dispersant is more preferably 0.03 to 3 % by mass, further preferably 0.05 to 2 % by mass.

Examples of the resin component include a polyester-based resin, a polyurethane-based resin such as a blocked polyisocyanate, a polyacrylate-based resin, a polyacrylamide-based resin, a polyether-based resin, a melamine-based resin, a terpene-based resin and the like, and these can be used alone, respectively, or in combination of two or more.

Examples of the organic solvent include, excepting the ones exemplified as the dispersing media, methyl alcohol, ethyl alcohol, n-propylalcohol, 2-propyl alcohol, 1,3-propanediol, 1,2-propanediol, 1,4-butanediol, 1,2,6-hexantril, 1-ethoxy-2-propanol, 2-butoxyethanol, ethylene glycol, diethylene glycol, triethylene glycol, polyethylene glycol having a weight-average molecular weight within the range of 200 or more and 1,000 or less, propylene glycol, dipropylene glycol, tripropylene glycol, polypropylene glycol having weight-average molecular weight within the range of 300 or more and 1,000 or less, N,N-dimethylformamide, dimethylsulfoxide, N-methyl-2-pyrrolidone, N,N-dimethylacetamide, glycerin, acetone and the like, and these can be used alone, respectively, or in combination of two or more.

Examples of the thickener include a clay mineral such as clay, bentonite or hectorite; an emulsion such as a polyester-based emulsion resin, an acrylic-based emulsion resin, a polyurethane-based emulsion resin or a blocked isocyanate; a cellulose derivative such as methyl cellulose, carboxymethyl cellulose, hydroxyethyl cellulose, hydroxypropyl cellulose, hydroxypropyl methylcellulose; a polysaccharide such as xanthane gum or guar gum, and the like, and these can be used alone, respectively, or in combination of two or more.

A surfactant which is different from the above organic components may be added. In a multicomponent solvent-system inorganic colloid dispersion, roughness of coating surface due to a difference in a volatile rate upon drying and bias of solid content are easily happened. These disadvantages are controlled by adding a surfactant into the composition for bonding of the present embodiment, and a composition for bonding that can form a uniform conductive coating film can be obtained.

The surfactant being usable in the present embodiment is not particularly limited, but any of an anionic surfactant, a cationic surfactant and a nonionic surfactant are usable, and includes, for example, an alkyl benzene sulfonate, a quaternary ammonium salt and the like. Since an effect can be obtained with a small additive amount, a fluorine-based surfactant is preferable.

As the method for adjusting the amount of the organic component within a predetermined range, adjustment by heating is simpler. Further, the amount of the organic component to be added on the occasion of producing inorganic particles can be adjusted. Cleaning conditions and the number of times after the inorganic particle adjustment may be changed. Heating can be conducted with an oven or an evaporator, and it can be conducted under reduced pressure. In the case of conducting under ordinary pressure, the heating can be conducted even in the atmosphere or in the inert atmosphere. In addition, for minute adjustment of an amount of the organic component, the above amine (and carboxylic acid) can be added later.

The bonding composition according to the present embodiment mainly contains inorganic colloid particles where the inorganic particles mentioned bellow become colloid as a primary component, but regarding a morphology of such inorganic colloid particles, for example, inorganic colloid particles configured by adhering an organic substance onto a portion of surfaces of inorganic particles, inorganic colloid particles where their surfaces are coated with an organic component using the above inorganic particles as a core, inorganic colloid particles that are configured by mixing these and the like can be exemplified, but it is not particularly limited. Among them, the inorganic colloid particles where their surfaces are coated with the organic component using the inorganic particles as a core are preferable. One skilled in the art can arbitrarily prepare inorganic colloid particles having the morphology using a known technology in the field.

The bonding composition according to the present embodiment is a fluent material that contains the colloid particles which is composed of the inorganic particles and the organic component as a main component, and other than the inorganic particles and the organic components which is the component of the inorganic colloid particles, there may be included organic components which do not configure the inorganic colloid particles, a dispersion medium, a residual reducing agent, and the like.

In the bonding composition of the present invention, the viscosity is lowered during the temperature rising step, and after the bonding composition is wetted and spread all over the desired interface to be bonded due to the lowering of the viscosity, the inorganic particles of the primary component are sintered, and thereby it is possible to form a good bonded layer without non-bonded part all over the surface. In addition, when the bonding composition is wetted and spread appropriately, it is possible to inhibit the formation of the fillet.

Furthermore, even when there is a region where the bonding composition is not wetted and spread when mounting the material to be bonded due to variation in the amount of applying on the surface to be bonded, since the region spreads wet by decreasing viscosity due to temperature rising, it is possible to reduce the influence of the applying amount on the bonding properties.

Further, in the bonding composition of the present embodiment, a viscosity at around 25 °C is preferably 10 to 50 Pa·s at a shear of 10 s$^{-1}$. When the viscosity at around 25 °C is 10 Pa·s or more at a shear of 10 s$^{-1}$, it is possible to inhibit the formation of the fillet by flowing out the bonding composition at mounting a chip due to too high flowability of the bonding composition. Further, when the viscosity at around 25 °C is 50 Pa·s or less at a shear of 10 s$^{-1}$, it is possible to prevent that the bonding composition becomes hard and (due to less flowability) is difficult to be applied.

Further, in the bonding composition of the present embodiment, a viscosity at around 60 °C is preferably 1 to 10 Pa·s at a shear of 10 s$^{-1}$. When the viscosity at around 60 °C is 1 Pa·s or more at a shear of 10 s$^{-1}$, it is possible to inhibit the formation of the fillet beyond the interface to be bonded because of too high flowability of the bonding composition during the temperature rising. Further, when the viscosity at around 60 °C is 10 Pa·s or less at a shear of 10 s$^{-1}$, it is possible to inhibit that non-bonded part is formed because the bonding composition cannot be spread all over the surface to be bonded due to less flowability of the bonding composition. When the amount of the dispersing agent which coats the particle surface is too small, the particles easily agglomerate and the viscosity of the bonding composition becomes large. When the amount of the dispersing agent which coats the particle surface is too large, the dispersibility of the particles is enhanced and the fluidity of the bonding composition is enhanced.

Further, in the bonding composition of the present embodiment, it is preferable that a thixotropic ratio (the viscosity at a temperature of around 25°C measured at a shear rate of 1 s$^{-1}$ is divided by the viscosity at a temperature of around 25°C measured at a shear rate of 10 s$^{-1}$) is 3 or more. By setting the thixotropic ratio to 3 or more, it is possible to prevent the bonding composition from wetting and spreading in a wide range at the time of applying, and it is possible to inhibit the formation of the fillet.

Further, in the bonding composition of the present embodiment, it is preferable that a thixotropic ratio (the viscosity at a temperature of around 25°C measured at a shear rate of 1 s$^{-1}$ is divided by the viscosity at a temperature of around 25°C measured at a shear rate of 10 s$^{-1}$) is 7 or less. By setting the thixotropic ratio to 7 or less, it is possible to prevent the deformation of the applied shape of the bonding composition, and it is possible to inhibit the formation of the fillet due to non-uniform spread of the bonding composition when the chip of LED or the like is mounted.

The bonding composition of the present invention is preferably used for bonding the LED (light emitting diode) chip and the substrate. As mentioned above, since the formation of the fillets can be inhibited by using the bonding composition of the present invention, it is possible to inhibit effectively the lowering of the light-emitting efficiency of the LED package which is caused by the formation of the fillet.

Furthermore, according to the bonding composition of the present invention, it is preferable that

in case of an LED (Light Emitting Diode) chip is laminated on a substrate where the bonding composition is applied, and the substrate and the LED (Light Emitting Diode) chip is bonded by sintering the bonding composition;
a sintered layer of the bonding composition is formed over almost of the interface of the substrate and the LED (Light Emitting Diode) chip,
a height of a fillet of the bonding composition formed at a side surface of the LED (Light Emitting Diode) chip is less than 10 μm.

When the height of a fillet of the bonding composition formed at a side surface of the LED (Light Emitting Diode) chip is less than 10 μm, it is possible to inhibit extremely effectively the lowering of the light-emitting efficiency of an LED package which is caused by the formation of the fillet.

By using the bonding composition of the present invention, it is possible to inhibit the height of the fillet regardless to the size and shape of the chip and the thickness of the sintered layer of the bonding composition. Here, for example, the size (area) of the chip can be 0.2 mm × 0.2 mm to 2.0 mm × 2.0 mm, and the thickness of the sintered layer can be 1 to 50 μm.

As a method for applying the bonding composition onto the substrate, any method can be arbitrarily selected and adopted, for example, from a dipping, a screen printing, a spray method, a barcode method, a spin-coating method, an inkjet method, a dispenser method, an application method by a brush, a casting method, a flexo method, a gravure method, an offset method, a transfer method, a hydrophilic/hydrophobic method and a syringe method and the like.

The viscosity can be adjusted by adjustment of the particle size of the inorganic particles, adjustment of content of an organic substance, adjustment of additive amounts of a dispersion medium and other components, adjustment of a blending ratio of each component, addition of thickener and the like. The viscosity of the bonding composition can be measured, for example, with a cone-plate viscometer (for example, Leometer MCR301 manufactured by AntonPaar).

(1-3) Mass loss of bonding composition

In the bonding composition of the present embodiment, the properties as the bonding composition are also optimized by controlling the weight loss in each situation.

The bonding composition of the present embodiment preferably has a weight loss of 0.5 % by mass or less when it is allowed to stand in the atmospheric circumstance at room temperature for 6 hours, and preferably has a weight loss of 3.0 % by mass or less when heating from room temperature to 100°C in an atmospheric circumstance at a temperature rising rate of 10 °C/min.

When the weight loss measured by allowing the bonding composition to stand for 6 hours in the atmospheric circumstance at room temperature exceeds 0.5 % by mass, the viscosity rises due to the volatilization of the components, which makes the handling property of the bonding composition bad. In order to maintain the printability of the bonding composition for a long time, it is more preferable that the weight loss measured by allowing the bonding composition to stand for 6 hours in the atmospheric circumstance at room temperature is 0.3% by mass or less.

Since the weight loss measured by allowing the bonding composition to stand for 6 hours in the atmospheric circumstance at room temperature is mainly attributable to the volatilization of the organic substances and the like used as organic substances and the dispersing agent, the content of the components having a low boiling point which remain in the bonding composition are reduced. For example, it can be suitably controlled by performing processing such as removal by an evaporator.

Further, in case where the weight loss measured by heating the bonding composition from room temperature to 100°C at a temperature rising rate of 10 °C/min in an atmospheric circumstance is more than 3.0 % by mass, since the components volatilize violently at room temperature to change the viscosity, the handling property of the bonding composition becomes bad. Here, the weight loss measured by heating the bonding composition from room temperature to 100°C in an atmospheric circumstance at a temperature rising rate of 10 °C/min is preferably 20.0 % by mass, more preferably 1.0 % by mass or less.

Since the weight loss measured by heating the bonding composition from room temperature to 100°C at a temperature rising rate of 10 °C/min is mainly attributable to organic substances having an SP value of 10 or more and organic substances used as a dispersing agent, the content of the components having a low boiling point which remain in the bonding composition are reduced. For example, it can be suitably controlled by performing processing such as removal by an evaporator.

Further, it is preferable that the bonding composition has a weight loss of 20.0 % by mass or less when the bonding composition is heated from room temperature to 500°C in an atmospheric circumstance at a temperature rising rate of 10 °C/min.

As mentioned above, when the bonding composition is heated up to 500 °C in an atmospheric circumstance, organic substances and the like are oxidatively decomposed and a majority is gasified and disappears. In case that a mass loss when heating the bonding composition from a room temperature to 500°C at a temperature rising rate of 10 °C/min in an atmospheric circumstance is more than 20 % by mass, the organic substances remain in the sintered layer (bonding layer) after the sintering to form voids, which results in the lowering of the bonding strength and the lowering of the conductivity of the sintered layer (bonding layer). To the contrary, in case that the mass loss when heating the bonding composition from a room temperature to 500°C at a temperature rising rate of 10 °C/min in an atmospheric circumstance is 20 % by mass or less, it is possible to obtain a sintered layer (bonding layer) having a high conductivity even at a low temperature bonding at around 200°C. On the other hand, when the mass loss of the bonding composition is too small, since dispersion stability in the colloidal state is damaged, the mass loss when heating the bonding composition from a room temperature to 500°C at a temperature rising rate of 10 °C/min in an atmospheric circumstance is preferably 0.1 % or more by mass, more preferably 0.5 to 18.0 % by mass.

The weight loss measured by heating the bonding composition from room temperature to 500°C at a temperature rising rate of 10 °C/min is mainly attributable to the total organic components contained in the bonding composition, and it can be suitably controlled by controlling the kinds and amounts of the components to be used as the materials.

(2) Production of bonding composition

In order to produce the bonding composition according to the present embodiment, it is necessary to prepare the inorganic particles (inorganic colloid particles) as the primary component which is covered with the organic component as the secondary component.

The methods for regulating the amount of the organic component and the weight loss are not particularly limited, and an easy method is to regulate by heating and reducing pressure. Also, the regulation may be conducted by regulating an amount of the added organic component at the preparation of the inorganic particles, or may be regulated by changing the washing conditions and the number of washings after preparation of the inorganic particles. The heating can be carried out by an oven, an evaporator, or the like. The heating temperature may be the range of from about 50 to 300°C, and the heating time may be several minutes to several hours. The heating may be carried out under a reduced pressure. By heating under a reduced pressure, the regulation of the amount of the organic material can be conducted at a lower temperature. When carrying out under a normal pressure, the regulation can be conducted in the atmosphere or in an inert atmosphere. Further, in order to regulate the amount of the organic material sensitively, an amine or a carboxylic acid may be added later.

As a result of the above adjustment, when the weight loss measured by allowing the bonding composition to stand for 6 hours in the atmospheric circumstance at room temperature is 0.5 % by mass or less and the weight loss measured by heating the bonding composition from room temperature to 100°C at a temperature rising rate of 10 °C/min in an atmospheric circumstance is 3.0 % by mass or less, the bonding composition of the present embodiment can be obtained. Further, it is preferable that the mass loss when heating the bonding composition from a room temperature to 500°C at a temperature rising rate of 10 °C/min in an atmospheric circumstance is 20 % by mass or less,

A method for preparing the inorganic particles coated with the organic component of the present invention is not particularly limited, and, for example, there is employed a method where preparing a dispersion which contains the inorganic particles, and subsequently, washing the dispersion. A process step for preparing the dispersion which contains the inorganic particles is, for example, in the followings, a process where metal salt (or metal ions) dissolved into a solvent should be reduced, and as reduction procedures, a procedure based upon a chemical reduction method should be adopted.

Namely, the inorganic particles coated with the above organic component can be prepared by reducing a raw material liquid (a part of the component may not be dissolved but may be dispersed) which contains the metal salt of metal constituting inorganic particles, an organic substance as the dispersant and a solvent (basically, an organic system such as toluene, but water may be contained).

As a result of the reduction, the inorganic colloid particles where the organic component as the dispersant is adhered onto at least a port of surfaces of the inorganic particles are obtained. The inorganic colloid particles can be supplied as the bonding composition of the present embodiment as it is, and as occasion demand, by adding to the dispersing medium in the process step mentioned after, the bonding composition of the inorganic colloid dispersion can also be obtained.

As a starting material in order to obtain the inorganic particles coated with the organic substance, various known metal salts or their hydrate can be used, and examples include a silver salt such as silver nitrate, silver sulfate, silver chloride, silver oxide, silver acetate, silver oxalate, silver formate, silver nitrite, silver chlorate or silver sulfide; a gold salt such as chlorauric acid or gold potassium chloride, gold sodium chloride; a platinum salt such as chloroplatinic acid, platinum chloride, platinum oxide or potassium chloroplatinate; a palladium salt such as palladium nitrate, palladium acetate, palladium chloride, palladium oxide or palladium suphate; and the like, but are not limited thereto as long as it can be dissolved into an appropriate solvent and can be reduced. Further, these can be used alone or in combination of two or more.

Further, the method to reduce the metal salts in the raw material liquid is not particularly limited, and example include a method by using a reducing agent, a method by irradiating a light such as ultraviolet rays, electron beams, ultrasonic waves or thermal energy, and the like. Among these, from a viewpoint of easy operation, the method by using the reducing agent is preferable.

Examples of the reducing agent include an amine compound such as dimethylaminoethanol, methyldiethanolamine, triethanolamine, phenidone or hydrazine; a hydrogen compound such as sodium boron hydride, hydrogen iodide or hydrogen gas; an oxide such as carbon monoxide, sulfurous acid; a low-valent metal salt such as ferrous sulfate, ferric oxide, ferric dumarate, ferrous lactate, ferric oxalate, ferric sulfide, tin acetate, tin chloride, tin diphosphate, tin oxalate, tin oxide or tin sulfate; a sugar such as ethylene glycol, glycerin, formaldehyde, hydroquinone, pyrogallol, tannin, tannic acid, salicylic acid or D-glucose; and the like, but are not limited thereto as long as it can be dissolved into an appropriate solvent and can be reduced. In case of using the above reducing agent, reduction reaction can be accelerated by adding light and/or heat.

As a specific method for preparing the metal particles (inorganic particles) coated with the organic substance by using the metal salt, the organic component, the solvent and the reducing agent, examples include a method where dissolving the metal salt into an organic solvent (for example, toluene and the like) to prepare a solution of the metal salt, and adding an organic substance as the dispersant to the solution of the metal salt, and then gradually adding dropwise the solution where the reducing agent is dissolved, and the like.

In the dispersion containing the inorganic particles coated with the organic component as the dispersant obtained in the above mentioned manner, an electrolyte concentration of the entire dispersion tends to be higher, because there are counter ions of metal salt, a residue of the reducing agent and the dispersant other than the inorganic particles. Since the dispersion in such a condition has a high conductivity, the inorganic particles tend to be coagulated and easy to be deposited. Alternatively, even if the inorganic particles liquid is not deposited, when the counter ions of the metal salt, a residue of the reducing agent or the dispersant in an amount of excess to the necessary amount for dispersing remains, three is a risk to make the conductivity worse. Then, the inorganic particles coated with the organic substance can be surely obtained by washing the solution containing the inorganic particles to remove the excess residues.

As the washing method, example include a method where steps for allowing to stand the dispersion containing the inorganic particles coated with the organic component for a certain period of time, and adding an alcohol (such as methanol) for stirring again after the generated supernatant is removed, and further allowing to stand the mixture for a certain period of time and then removing the generated supernatant are repeated several times; a method where centrifugal separation is conducted instead of the above standing; a method where desaltation by using ultra-filtration equipment, ion exchange equipment or the like. The inorganic particles coated with the organic component of the present embodiment can be obtained by such washing for removing the organic solvent.

Among the present embodiments, the inorganic colloid dispersion is obtained by mixing the inorganic particles coated with the organic component obtained above and the dispersion medium explained in the embodiment above. The method for mixing the inorganic particle coated with the organic component and the dispersion medium is not particularly limited, and can be conducted according to the conventional known method by using an agitator or a stirrer. The mixture may be stirred by using a spatula or the like, or thereto an appropriate output of ultrasonic homogenizer may be irradiated. Namely, the bonding composition according to the present invention can be prepared by washing the inorganic particles (colloid), adding the dispersing medium to be pasted, and then drying under reduced pressure.

By controlling the kinds and amounts of the inorganic particles, dispersing medium, other organic substances or the drying step under reduced pressure, etc., it is possible to make the viscosity of the bonding composition at around 25°C at a shear rate of $10 \text{ s}^{-1}$ being 10 to 50 Pa·s and the viscosity at around 60°C at a shear rate of $10 \text{ s}^{-1}$ being 1 to 10 Pa·s.

By controlling the kinds and amounts of the inorganic particles, dispersing medium, other organic substances or the drying step under reduced pressure, etc., it is possible to make the thixotropic ratio defined by dividing the viscosity at a temperature of around 25°C measured at a shear rate of $1 \text{ s}^{-1}$ by the viscosity at a temperature of around 25°C measured at a shear rate of $10 \text{ s}^{-1}$ is 3 to 7.

When obtaining the inorganic colloid dispersion containing a plurality of metals, the manufacturing method is not particularly limited, and ,when manufacturing the inorganic colloid dispersion made of silver and other metal, in the preparation procedures of the inorganic particles coated with the organic substance, a dispersion containing the inorganic particles and other dispersion containing the other inorganic particles are separately prepared, and then to be mixed, or a silver ion solution and other metal ion solution may be mixed and then reduced.

(3) Bonding method

When using the bonding composition according to the present embodiment, the high bonding strength can be obtained in the bonding of members with heating at a relatively low bonding temperature. Namely, a first member to be bonded and a second member to be bonded can be bonded by a step for applying the bonding composition where the bonding composition is applied between the first member to be bonded (LED (Light Emitting Diode) chip) and the second member to be bonded (substrate), and a bonding step where the bonding composition applied between the first member to be bonded and the second member to be bonded is sintered at a desired temperature (for example, 300°C or less, preferably between 150 and 200°C) to bond (form the bonding layer). In this case, a pressure may be added, but a sufficient bonding strength can be obtained without a particular additional pressure, this is one of the advantages of the present invention. Further, when sintering, temperature can be increased and decreased in stepwise. Further, it is also possible to previously apply a surfactant, a surface activating agent or the like on surfaces of the members to be bonded.

Further, by using the bonding composition of the present embodiment, it is possible to obtain a good bonded body even when the bonding step by heating is long after applying the bonding composition to the surface to be bonded. Therefore, the bonding composition of the present embodiment can be suitably used for mass production lines of electronic devices, and the like.

The inventor of the present invention, as a result of intensive study, has found that the first member to be bonded and the second member to be bonded can be more surely bonded with a high bonding strength can be obtained (bonded body being obtained), and the formation of the fillet is effectively inhibited, when using the bonding composition according to the present embodiment mentioned above as the bonding composition in the step for applying the bonding composition.

Herein, "application" of the bonding composition of the present embodiment is a concept including both a case of planarly applying and another case of linearly applying (drawing) the bonding composition. It is possible that the configuration of a coating film made of the bonding composition in the state before applying and sintering by heating is desired one. Therefore, in the bonded body of the present embodiment after sintering by heating, the bonding composition is a concept including both a planar bonding layer and a linear bonding layer, and these planar bonding layer and linear bonding layer may be continuous or discontinuous, or may include a continuous portion and a discontinuous portion.

As the first member to be bonded and the second member to be bonded that are usable in the present embodiment, they should be ones where the bonding composition is applied, and that are sintered and bonded by heating, and there is no particular limitation, but members having a thermal resistance to the extent of not damaging at a temperature upon bonding are preferable.

As materials constituting such members to be bonded, for example, polyester, such as polyamide (PA), polyimide (PI), polyamide imide (PAI), polyethylene terephthalate (PET), polybutylene terephthalate (PBT) or polyethylene naphthalate (PEN); polycarbonate (PC), polyether sulfone (PES), vinyl resin, fluorine resin, liquid crystal polymer, ceramics, glass, metal or the like can be exemplified, but among them, metallic members to be bonded are preferable. The reason why the metallic members to be bonded are preferable is because they excel in thermal resistance, and, they excel in affinity with the bonding composition of the present invention where inorganic particles are metal.

Further, the members to be bonded may be various shapes, such as plate-like or strip-like, and it may be rigid or flexible. Thickness of the substrate may also be optionally selected. For improvement of adherence property or adhesiveness or other purpose, a member where a surface layer is formed, or a member where surface treatment such as hydrophilic treatment is carried out may be used.

In the process to apply the bonding composition onto the members to be bonded, it is possible to use various methods, and as described above, it is possible to employ optionally a method selected among dipping, screen print, a spray method, a barcode method, a spin-coating method, an inkjet method, a dispenser method, a pin-transferring method, an application method by a brush, a casting method, a flexo method, a gravure method, and a syringe method.

The coating film after being applied as mentioned above is sintered by heating at, for example, 300°C or less within the range that does not damage the members to be bonded, and the bonded body of the present embodiment can be obtained. In the present embodiment, as mentioned above, because the bonding composition of the present embodiment is used, the bonding layer having superior adhesiveness with regard to the members to be bonded can be obtained, and a strong bonding strength can be more surely obtained.

In the present embodiment, when the bonding composition contains a binder component, from viewpoints to improve strength of the bonding layer and improvement of bonding strength between the members to be bonded, the binder component is also baked, but depending upon circumstances, a baking condition is controlled and the binder component may be removed all with adjustment of the viscosity of the bonding composition for applying to various printing methods as a primary purpose of the binder component.

The method for sintering is not particularly limited, but for example, the members to be bonded can be bonded by sintering so as to adjust the temperature of the bonding composition applied or drawn on the members to be bonded, for example, at 300°C or less, for example, by using a conventionally known oven or the like. The lower limit of the temperature for sintering is not necessarily limited, and it is preferable that it is a temperature than can made bonding of the members to be bonded, and, it is a temperature within the range that does not impair the effect of the present invention. Herein, in the bonding composition after sintering above, from a point to obtain greater bonding strength as much as possible, the lesser a residue of the organic substance is, the better, but a portion of the organic substance may remain within the scope that does not impair the effect of the present invention.

Furthermore, the bonding composition of the present invention contains the organic substance, but unlike the conventional one utilizing thermal-setting such as epoxy resin, it does not obtain the bonding strength after sintering due to action of the organic substance, but it obtains sufficient bonding strength by fusion of the fused inorganic particles. Consequently, after bonding, even if the bonding composition is placed in such an environment to be used that a temperature is higher than a bonding temperature, and the residual organic substance is deteriorated or decomposed to be disappeared, the bonding strength will never be decreased, therefore, it is excellent in the thermal resistance.

According to the bonding composition of the present embodiment, since bonding having a bonding layer developing a high conductivity can be realized, even with sintering by heating at a low temperature, for example, at around 150 to 200°C, the members to be bonded which comparatively weak to heat, can be bonded. Further, a sintering time is not particularly limited, and it should be a sintering time for enabling to bond the members at the sintering temperature.

In the present embodiment, in order to further enhance the adhesiveness with the members to be bonded and the bonding layer, the surface treatment of the members to be bonded may be conducted. Examples of the surface treatment include a dry treatment such as corona treatment, plasma treatment, UV treatment or electron beam treatment; a method where a primer layer and a conductive paste receptive layer is previously formed on the substrate; and the like.

(4) Bonded body of electronic parts

The bonded body of electronic parts according to the present embodiment is a bonded body of electronic parts where the LED (Light Emitting Diode) chip is bonded to the substrate, and the substrate and the LED (Light Emitting Diode) chip are bonded by using the bonding composition of the present invention.

When using the bonding composition of the present invention, even in case that the bonded body of electronic parts is mass-produced, the sintered layer of the bonding composition are formed almost over the interface to be bonded of the substrate and the LED (Light Emitting Diode) chip, and at the same time, the height of a fillet of the bonding composition formed at a side surface of the LED (Light Emitting Diode) chip is less than 10 $\mu$m. As a result, it is possible to inhibit effectively the lowering of the light-emitting efficiency of the LED package which is caused by the formation of the fillet.

The size and shape of the chip, and the thickness of the sintered layer of the bonding composition are not particularly limited, and, for example, the size (area) of the chip may be 0.2 mm x 0.2 mm to 2.0 mm x 2.0 mm, and the thickness of the sintered layer may be 1 to 50 $\mu$m.

In the above, the typical embodiments of the present invention are explained, but the present invention is not be limited thereto. For example, in the embodiments above, the metal colloid dispersion where metal particles have been employed as the inorganic particles is explained, and for example, inorganic particles such as tin-doped indium, alumina, barium titanate or iron lithium phosphate, excelling in, for example, conductivity, thermal conductivity, dielectricity, ion conductivity or the like, can also be used (mixed).

In the following, in Examples, the bonding composition of the present invention is further explained, but the present invention is not limited to these examples at all.

EAXMPLE

«Example 1»

400 ml of toluene (first class grade chemicals available from Wako Pure Chemical Industries, Ltd.) and 30 g of hexylamine (first class grade chemicals available from Wako Pure Chemical Industries, Ltd.) were mixed and sufficiently stirred with a magnetic stirrer. While stirring, 10 g of silver nitrate (special class grade chemicals available from TOYO Chemical Industries, Ltd.) was added, and after dissolving the silver nitrate, 10 g of oleic acid (first class grade chemicals available from Wako Pure Chemical Industries, Ltd.) was added. Thereto, a 0.01 g/ml of sodium borohydride solution prepared by adding 1 g of sodium borohydride (Wako Pure Chemical Industries, Ltd.) into 100 ml of ion-exchanged water was added dropwise, and then a dispersion containing silver fine particles.

After stirring the dispersion containing silver fine particles for one hour, 300 ml of methanol (special class grade chemicals available from Wako Pure Chemical Industries, Ltd.) was added, and the silver fine particles were coagulated and precipitated. In addition, after the silver particles were completely precipitated with centrifugal separation, toluene and methanol which were supernatants, were removed and excess organic substances were removed to obtain about 5 g of silver fine particles. The particle size of the silver particles was measured according to the method mentioned the above paragraph [0037], and was 31 nm.

0.70 g of 1-decanol (first class grade chemicals available from Wako Pure Chemical Industries, Ltd.) was added as the dispersant to 5 g of the thus obtained silver fine particles and stirred. By evaporating the remaining small amount of toluene and methanol under reduced pressure for a few minutes with a diaphragm pump, a bonding composition 1 was obtained.

[Evaluation Test]

(1) Shearing viscosity of bonding composition

The viscosity of the bonding composition 1 was measure by using a cone-plate viscometer (rheometer MCR301 available from Anton Paar GmbH). The measurement conditions were a measurement mode: shearing mode, shearing rate: 10 s$^{-1}$, cone plate (CP-50-2; diameter 50 mm, angle 2°, gap 0.045 mm), amount of sample: 5 g, measurement temperatures: 25°C, 40°C, 60°C, 80°C, and the obtained results are shown in Table 1, respectively.

(2) Evaluation of height of fillet

By using Die Bonder (available from HISOL, Ltd.), 10 $\mu$g of the bonding composition 1 was put onto an alumina plate (10 mm x 10 mm) where its surface had been gold-plated, and a commercially available blue LED chip (ES-CADBV24H available from EPISTAR Inc., an area of base: 600 $\mu$m $\times$ 600 $\mu$m, height: 150 $\mu$m, weight: 0.2 mg) was laminated lightly thereon.

Next, the laminated body was placed into a circulating hot air oven, heated up to 200°C at a rate of 10 °C/min under an atmospheric circumstance, and kept for 120 minutes. After cooling down to 50°C or less, the laminated body was taken out from the circulating hot air oven, and the height of the fillet was measured by a video microscope (available from Keyence Inc.). The obtained results are shown in Table 1.

(3) Measurement of bonding strength

By using Bonding Tester (available from Rhesca Corporation), the shear strength test was conducted with respect to the laminated body after the sintering treatment. The bonding strength at the peeling off was divided by the area of base of the chip, the bonding strength (MPa) per unit area was calculated, and the obtained results are shown in Table 1.

(4) Evaluation of light-emitting property

By using the spectrophotometric apparatus (available from Hamamatsu Photonics KK), the brightness of the blue LED chip after the above sintering treatment was measured. The brightness after continuous lighting for 1000 hours under an environment at a temperature of 85°C and a humidity of 85% is shown as a relative value with the initial brightness as 100, and the obtained results are shown in Table 1. The light emission intensity (initial) of the Comparative Example shown in Table 1 shows the relative intensity when the light emission intensity of Example 1 is 100.

(5) Heat cycle test

The laminated body was put in a hot-cold shock testing apparatus (TSA-41L available from ESPEC CORP.), and kept at the higher temperature side of 125°C for 30 min. and at the lower temperature side of -40°C for 30 min. One exposure to the higher temperature and the lower temperature is assumed to be one cycle, the shearing strength after 1000 cycles was measured, and the obtained results are shown in Table 1. The measurement of the shearing strength was achieved according to the method described in the above (3).

(6) Measurement of bonding ratio

With respect to the laminated body after bonding, the blue LED chip was peeled off from the alumina plate, and the bonding layer on the surface of the alumina plate and/or the blue LED chip was observed with a video microscope. In the contrast mode, the area ratio of the bonding layer to the area of base of the blue LED chip was obtained, and the bonding ratio (%) was measured. The obtained values are shown in Table 1.

<<Example 2>>

A bonding composition 2 was obtained in the same manner as in Example 1 except that the addition amount of oleic acid was 7 g. Various properties were evaluated in the same manner as in Example 1, and the obtained results are shown in Table 1.

<<Example 3>>

A bonding composition 3 was obtained in the same manner as in Example 1 except that the addition amount of oleic acid was 15 g. Various properties were evaluated in the same manner as in Example 1, and the obtained results are shown in Table 1.

<<Example 4>>

A bonding composition 4 was obtained in the same manner as in Example 1 expect that 5 g of oleic acid and 5 g of hexanoic acid (special class grade chemicals available from Wako Pure Chemical Industries, Ltd.) were added instead of adding 10 g of oleic acid, and 0.2 g of Telsolve MTPH (available from Nippon Terpene Chemical Co., Ltd.) and 0.5 g of 1-decanol were used as the dispersing medium. Various properties were evaluated in the same manner as in Example 1, and the obtained results are shown in Table 1.

<<Example 5>>

A bonding composition 5 was obtained in the same manner as in Example 1 except that 10 g of hexanoic acid was added instead of oleic acid. Various properties were evaluated in the same manner as in Example 1, and the obtained results are shown in Table 1.

<<Example 6>>

A bonding composition 6 was obtained in the same manner as in Example 1 expect that 30 g of octylamine (special class grade chemicals available from Wako Pure Chemical Industries, Ltd.) was added instead of hexylamine, and 0.4 g of dihydroterpinyl acetate (available from Nippon Terpene Chemical Co., Ltd.) and 0.3 g of 1-decanol were used as the dispersing medium. Various properties were evaluated in the same manner as in Example 1, and the obtained results are shown in Table 1.

<<Example 7>>

A bonding composition 7 was obtained in the same manner as in Example 1 expect that 30 g of octylamine was added instead of hexylamine. Various properties were evaluated in the same manner as in Example 1, and the obtained results are shown in Table 1.

<<Comparative Example 1>>

A comparative bonding composition 1 was obtained in the same manner as in Example 1 expect that 3 g of hexanoic acid was added instead of oleic acid, and 0.7 g of terpineol (first class grade chemicals available from Wako Pure Chemical Industries, Ltd.) was used as the dispersing medium. Various properties were evaluated in the same manner as in Example 1, and the obtained results are shown in Table 1.

<<Comparative Example 2>>

A comparative bonding composition 2 was obtained in the same manner as in Example 1 except that the addition amount of oleic acid was 2 g, and 0.7 g of 1,3-butandiol (special class grade chemicals available from Wako Pure Chemical Industries, Ltd.) was used as the dispersing medium. Various properties were evaluated in the same manner as in Example 1, and the obtained results are shown in Table 1.

<<Comparative Example 3>>

A comparative bonding composition 3 was obtained in the same manner as in Example 1 except that the addition amount of oleic acid was 15 g, and further 5 g of dodecylamine (first class grade chemicals available from Wako Pure Chemical Industries, Ltd.) was added, and 0.4 g of Telsolve MTPH and 0.3 g of 1-decanol were used as the dispersing medium. Various properties were evaluated in the same manner as in Example 1, and the obtained results are shown in Table 1.

<<Comparative Example 4>>

A comparative bonding composition 4 was obtained in the same manner as in Example 1 except that 10 g of dodecylamine and 10 g of hexanoic acid were added instead of oleic acid. Various properties were evaluated in the same manner as in Example 1, and the obtained results are shown in Table 1.

<<Comparative Example 5>>

A comparative bonding composition 5 was obtained in the same manner as in Example 1 except that the addition amount of oleic acid was 15 g, and further 10 g of hexanoic acid was added, and 0.5 g of Telsolve MTPH and 0.2 g of 1-decanol were used as the dispersing medium. Various properties were evaluated in the same manner as in Example 1, and the obtained results are shown in Table 1.

[Table 1]

| | | Ex.1 | Ex.2 | Ex.3 | Ex.4 | Ex.5 | Ex.6 | Ex.7 | Com.Ex.1 | Com.Ex.2 | Com.Ex.3 | Com.Ex.4 | Com.Ex.5 |
|---|---|---|---|---|---|---|---|---|---|---|---|---|---|
| Weight loss rate(25-500°C) | | 14.6 | 14.2 | 17.4 | 14.1 | 15.7 | 13.1 | 15.2 | 12.7 | 12.5 | 21.2 | 22.4 | 20.2 |
| Viscosity (25°C,10 s$^{-1}$/Pa·s | | 14.7 | 23.5 | 13.9 | 43.2 | 19.8 | 45.3 | 35.6 | 28.6 | 63.1 | 34.2 | 9.5 | 59.4 |
| Viscosity (40°C,10 s$^{-1}$/Pa·s | | 10.1 | 16.9 | 7.5 | 19.5 | 15.4 | 24.2 | 16.5 | 18.5 | 35.4 | 12.1 | 6.4 | 29.5 |
| Viscosity (60°C,10 s$^{-1}$/Pa·s | | 5.7 | 7.8 | 2.4 | 3.2 | 9.3 | 9.7 | 7.5 | 13.7 | 19.5 | 0.9 | 3.9 | 9.3 |
| Viscosity (80°C,10 s$^{-1}$/Pa·s | | 21.2 | 19.8 | 23.5 | 19.8 | 26.9 | 16.5 | 21.7 | 34.7 | 34.2 | 8.6 | 18.7 | 16.5 |
| Fillet height /$\mu$m | | 0 | 0 | 0 | 0 | 0 | 0 | 0 | 0 | Could not applied | 12 | 21 | Could not applied |
| LED brightness | Initial | 100 | 100 | 100 | 100 | 100 | 100 | 100 | 100 | | 84 | 87 | |
| LED brightness | After 1000hrs | 99 | 100 | 100 | 99 | 100 | 98 | 99 | 97 | | 69 | 70 | |
| Shear strength/MPa | Initial | 36 | 41 | 38 | 40 | 34 | 36 | 39 | 32 | | 35 | 37 | |
| Shear strength/MPa | After 1000hrs | 34 | 40 | 35 | 40 | 33 | 35 | 38 | 11 | | 19 | 18 | |
| Bonding rate /% | | 100 | 99 | 100 | 98 | 99 | 97 | 100 | 85 | | 100 | 100 | |

From the results shown in Table 1, there can be seen that the viscosity of the bonding composition according to the examples of the present invention is lowered by rising the temperature from 25°C to 60°C (Example 1 to Example 7). Further, the viscosity at 25°C is 10 to 50 Pa·s at a shear rate of 10 s$^{-1}$ and the viscosity at 60°C is 1 to 10 Pa·s at a shear rate of 10 s$^{-1}$. On the other hand, in Comparative Example 1 to Comparative Example 3, the viscosity at 60°C is outside the range of 1 to 10 Pa·s, and in Comparative Example 2, Comparative Example 4 and Comparative Example 5, the viscosities at 25°C are outside the range of 10 to 50 Pa·s.

Further, in case of using the bonding composition according to the examples of the present invention, the height of the fillet is 0 μm and the bonding ratio is 97 to 100 %, there can be seen that the bonding composition completely wetted and spreads on the bonding surface, and the formation of the fillet is inhibited. In addition, the LED brightness shows high values both at the initial stage and 1000 hours continuous lighting, and the shear strength also shows high values both at the initial stage and after the heat cycle test at 1000 cycles.

In contrast, in Comparative Example 2 and Comparative Example 5 where the viscosity at 25°C is higher than 50 Pa·s at a shear rate of 10 s$^{-1}$, the comparative bonding compositions could not be applied to the surface to be bonded. In Comparative Example 4 where the viscosity at 25°C is lower than 10 Pa·s at a shear rate of 10 s$^{-1}$, a high fillet is formed, and sufficient LED brightness is not obtained, and also the shear strength after the heat cycle test is remarkably decreased.

In Comparative Example 1, in which the viscosity at 60°C is higher than 10 Pa·s at a shear rate of 10 s$^{-1}$, though the formation of the fillet is inhibited, the bonding ratio is a low value (85 %), and the shear strength after the heat cycle test is remarkably decreased.

**Claims**

1. A bonding composition comprising inorganic particles as a primary component and an organic component as a secondary component, wherein
   a viscosity of the composition decreases upon a rise in temperature, and
   the inorganic particles are sintered to each other following the decrease in viscosity.

2. The bonding composition according to Claim 1, wherein a viscosity at around 25 °C is 10 to 50 Pa·s at a shear of 10 s$^{-1}$.

3. The bonding composition according to Claim 1 or 2, wherein a viscosity at around 60 °C is 10 to 50 Pa·s at a shear of 10 s$^{-1}$.

4. The bonding composition according to any one of Claims 1 to 3, which comprises a dispersing agent having a boiling point of 200 °C or more.

5. The bonding composition according to any one of Claims 1 to 4, wherein the composition is used for bonding an LED (Light Emitting Diode) chip and a substrate.

6. A bonded body of electronic parts where an LED (Light Emitting Diode) is bonded to a substrate, wherein
   a sintered layer of the bonding composition according to any one of Claims 1 to 4 is formed over almost of an interface of the substrate and the LED (Light Emitting Diode) chip, and
   a height of a fillet of the bonding composition formed at a side surface of the LED (Light Emitting Diode) chip is less than 10 μm.

## INTERNATIONAL SEARCH REPORT

| International application No. |
| --- |
| PCT/JP2016/004781 |

### A. CLASSIFICATION OF SUBJECT MATTER

*B22F7/08*(2006.01)i, *B22F1/02*(2006.01)i, *C09J1/00*(2006.01)i, *C09J11/06*
(2006.01)i, *H01B1/22*(2006.01)i, *H05K3/32*(2006.01)i, *B22F1/00*(2006.01)n

According to International Patent Classification (IPC) or to both national classification and IPC

### B. FIELDS SEARCHED

Minimum documentation searched (classification system followed by classification symbols)
B22F7/08, B22F1/02, C09J1/00, C09J11/06, H01B1/22, H05K3/32, B22F1/00

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | WO 2012/169076 A1 (DOWA Electronics Materials Co., Ltd.), 13 December 2012 (13.12.2012), paragraphs [0039], [0066] to [0075], [0092] to [0093], [0100] & US 2014/0113109 A1 paragraphs [0047], [0074] to [0083], [0106]; tables 1 to 2 & EP 2719486 A1          & TW 201249943 A1 & CN 103608140 A          & KR 10-2014-0035996 A | 1-6 |

| ☒ | Further documents are listed in the continuation of Box C. | ☐ | See patent family annex. |
| --- | --- | --- | --- |

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered  to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 23 January 2017 (23.01.17) | 07 February 2017 (07.02.17) |

| Name and mailing address of the ISA/ | Authorized officer |
| --- | --- |
| Japan Patent Office 3-4-3,Kasumigaseki,Chiyoda-ku, Tokyo 100-8915,Japan | Telephone No. |

Form PCT/ISA/210 (second sheet) (January 2015)

**INTERNATIONAL SEARCH REPORT**

International application No.

PCT/JP2016/004781

C (Continuation). DOCUMENTS CONSIDERED TO BE RELEVANT

| Category* | Citation of document, with indication, where appropriate, of the relevant passages | Relevant to claim No. |
|---|---|---|
| A | WO 2011/155615 A1 (DOWA Electronics Materials Co., Ltd.), 15 December 2011 (15.12.2011), paragraphs [0058], [0076] & US 2013/0081759 A1 paragraphs [0070], [0087] & EP 2581156 A1 & CN 102958631 A & KR 10-2013-0101986 A & TW 201143960 A1 | 4 |
| A | US 2010/0084599 A1 (LEWIS Jennifer A.), 08 April 2010 (08.04.2010), & WO 2010/040034 A2 | 1-6 |
| P,X | WO 2016/067599 A1 (Bando Chemical Industries, Ltd.), 06 May 2016 (06.05.2016), paragraphs [0124] to [0127], [0131] & TW 201615785 A | 1-2,4-5 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008178911 A